# EUROPEAN PATENT APPLICATION

(11) **EP 1 469 533 A2**
(43) Date of publication of application: **20.10.2004**
(21) Application number: 04008762.9
(22) Date of filing: 13.04.2004
(51) Int. Cl.: H01L 51/20

(54) **Organic electroluminescent element that supresses generation of ultraviolet light and lighting system that has organic electroluminescent element**

(30) Priority: 14.04.2003 JP 2003108631; 14.04.2003 JP 2003108632
(71) Applicant: Kabushiki Kaisha Toyota Jidoshokki, Kariya-shi, Aichi-ken (JP)
(72) Inventor: Ito, Hironori, 2-1, Toyoda-cho Kariya-shi, Aichi-ken (JP); Kato, Yoshifumi, 2-1, Toyoda-cho Kariya-shi, Aichi-ken (JP); Noritake, Kazuto, 2-1, Toyoda-cho Kariya-shi, Aichi-ken (JP); Kawaguchi, Ryuta, 2-1, Toyoda-cho Kariya-shi, Aichi-ken (JP)
(74) Representative: Leson, Thomas Johannes Alois, Dipl.-Ing.

(57) **Abstract**

An organic electroluminescent element including an organic luminescent material having electroluminescent characteristics and which suppresses generation of ultraviolet light. The organic luminescent material is made only of a material that emits light having a wavelength of no less than 380 nm and no more than 800 nm.

## Description

### BACKGROUND OF THE INVENTION

The present invention relates to an organic electroluminescent element that suppresses generation of ultraviolet light, and to a lighting system that has the organic electroluminescent element.

Lighting systems used for a particular purpose are required to generate suppressed amounts of ultraviolet light. Such lighting systems include lighting systems used for lighting a place where attraction of insects is undesirable, or a place where a patient having a light-sensitive disorder or a patient having xeroderma pigmentosum syndrome is likely to be exposed to the light. The lighting systems also include lighting systems for lighting exhibits. Japanese Laid-Open Patent Publication No. 9-92213 and No. 9-49922 disclose lighting systems that are improved to meet these requirements. The lighting systems of the above publications are provided with an ultraviolet absorption coating or an ultraviolet protection filter to reduce ultraviolet light produced by the lighting systems.

### SUMMARY OF THE INVENTION

Accordingly, it is an objective of the present invention to provide a new organic electroluminescent element that minimizes generation of ultraviolet light and to provide a new lighting system that has the organic electroluminescent element.

To achieve the above objective, the present invention provides an organic electroluminescent element. The organic electroluminescent element includes an organic luminescent material having electroluminescent characteristics and which suppresses generation of ultraviolet light. The organic luminescent material is made only of a material that emits light having a wavelength of no less than 380 nm and no more than 800 nm.

The present invention provides another organic electroluminescent element. The organic electroluminescent element includes a plurality of organic luminescent materials having electroluminescent characteristics and which suppresses generation of ultraviolet light. The organic luminescent materials are made only of materials that emit light having a wavelength of no less than 380 nm. Light emitted from at least one of the organic luminescent materials has a wavelength of no more than 800 nm.

The present invention provides yet another organic electroluminescent element. The organic electroluminescent element includes an organic luminescent material having electroluminescent characteristics and which suppresses generation of ultraviolet light. The organic luminescent material is made only of a material that emits light having a peak wavelength of which is within a visible light range.

In another aspect of the present invention, a lighting system for suppressing generation of ultraviolet light is provided. The lighting system includes a substrate and an organic electroluminescent element located on the substrate. The organic electroluminescent element includes an organic luminescent material having electroluminescent characteristics and suppresses generation of ultraviolet light. The organic luminescent material is made only of a material that emits light having a wavelength of no less than 380 nm and no more than 800nm.

The present invention provides another lighting system for suppressing generation of ultraviolet light. The lighting system includes a substrate and an organic electroluminescent element located on the substrate. The organic electroluminescent element includes a plurality of organic luminescent materials having electroluminescent characteristics and suppresses generation of ultraviolet light. The organic luminescent materials are made only of materials that emit light having a wavelength of no less than 380 nm. The wavelength of light emitted from at least one of the organic luminescent materials is no more than 800 nm.

The present invention provides yet another lighting system for suppressing generation of ultraviolet light. The lighting system includes a substrate and an organic electroluminescent element located on the substrate. The organic electroluminescent element includes an organic luminescent material having electroluminescent characteristics and suppresses generation of ultraviolet light. The organic luminescent material is made only of a material that emits light having a peak wavelength of which is within a visible light range.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a perspective view illustrating a lighting system according to one embodiment of the present invention;
Fig. 2 is a cross-sectional view illustrating an organic electroluminescent element in the lighting system shown in Fig. 1; and
Fig. 3 is a graph showing a spectrum of light emitted from the organic electroluminescent element in the lighting system shown in Fig. 1.

### DETAILED DESCRIPTION OF THE PREFERRED EMBODIMENTS

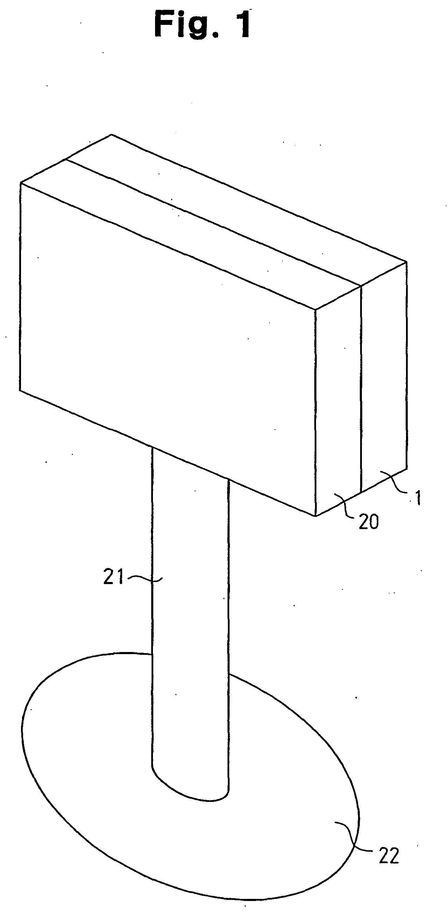

A preferred embodiment of the present invention will now be described with reference to Figs. 1 to 3.

As shown in Fig. 1, a lighting system of the preferred embodiment is provided with a substrate 20 and an organic electroluminescent element 1, which is attached to the substrate 20. The electroluminescent element 1 includes a pair of electrodes (anode and cathode) and a light emitting layer, which is arranged between the electrodes. Both the electrodes and the light emitting layer are not shown in Fig. 1. The main component of the light emitting layer is organic material, which contains organic luminescent material. The organic luminescent material in the light emitting layer emits light when voltage is applied between the electrodes. In other words, the organic luminescent material has electroluminescent characteristics.

The light emitting layer transports at least one of holes and electrons by the power of an electric field to recombine, in the light emitting layer, the holes injected into the light emitting layer from the anode with the electrons injected into the light emitting layer from the cathode. Recombination of the holes and the electrons generates excitons, which emit light when moving back toward the ground state. That is, the light emitting layer has a function to receive holes from the anode, a function to receive electrons from the cathode, a function to transport at least one of holes and electrons, that is, to transport at least one carrier, a function to generate excitons by recombination of holes and electrons, and a function to emit light when the excitons move back to the ground state.

The organic luminescent material in the light emitting layer, or the organic luminescent material included in the organic electroluminescent element 1, is made only of materials that emit light having a wavelength of no less than 380 nm and no more than 800 nm. Therefore, the light emitted when the excitons move back to the ground state, that is, the light emitted from the light emitting layer of the organic electroluminescent element 1 is light having only a wavelength of no less than 380 nm and no more than 800 nm.

The organic luminescent material may be either fluorescent material (fluorescent dye), which includes fluorescent brightener, or phosphorescent material (phosphorescent dye). The fluorescent material mainly consists of organic material and emits light when singlet excitons transit to the ground state under normal temperature. The phosphorescent material mainly consists of organic material and emits light when singlet and triplet excitons transit to the ground state under normal temperature.

The organic luminescent material may serve, in the light emitting layer, not only a first function to emit electroluminescence but at least one of a second function to permit the holes and electrons to be recombined, a third function to transport at least one of the holes and the electrons, and a fourth function to receive at least one of the holes and the electrons from either electrode.

Material that is capable of serving the first to fourth functions, or particularly, the first to third functions in the light emitting layer is typically Alq3 and Be-benzoquinolinol, which is abbreviated as BeBq2. Other examples of the material is fluorescent materials including: benzoxazole-based fluorescent brightener such as 2,5-bis(5,7-di-t-pentyl-2-benzoxazolyl)-1,3,4-thiadiazole, 4,4'-bis(5,7-bentyl-2-benzoxazolyl) stilbene, 9,4'-bis[5,7-di-(2-methyl-2-butyl)-2-benzoxazolyl] stilbene, 2,5-bis(5,7-di-t-bentyl-2-benzoxazolyl) thiophene, 2,5-bis([5-α,α-dimethylbenzyl]-2-benzoxazolyl) thiophene, 2,5-bis[5,7-di-(2-methyl-2-butyl)-2-benzoxazolyl]-3,4-diphenylthiophene, 2,5-bis(5-methyl-2-benzoxazolyl) thiophene, 4,4'-bis(2-benzoxazolyl) biphenyl, 5-methyl-2-[2-[4-(5-methyl-2-benzoxazolyl) phenyl] vinyl] benzoxazolyl, and 2-[2-(4-chlorophenyl)vinyl] naphtho [1,2-d] oxazole; benzothiazole-based fluorescent brightener such as 2,2'-(p-phenylenedivinylene)-bisbenzothiazole; benzoimidazole-based fluorescent brightener such as 2-[2-[4-(2-benzoimidazolyl) phenyl] vinyl] benzoimidazole and 2-[2-(4-carboxyphenyl) vinyl] benzoimidazole; 8-hydroxyquinoline metal complex such as bis(8-quinolinol) magnesium, bis(benzo-8-quinolinol) zinc, bis(2-methyl-8-quinolinolato) aluminum oxide, tris(8-quinolinol) indium, tris(5-methyl-8-quinolinol) aluminum, 8-quinolinol lithium, tris(5-chloro-8-quinolinol) gallium, bis(5-chloro-8-quinolinol) calcium, poly[zinc-bis(8-hydroxy-5-quinolinol) methane]; metal chelated oxinoid compound such as dilithium epindolidione; styrylbenzene compound such as 1,4-bis(2-methylstyryl) benzene, 1,4-(3-methylstyryl) benzene, 1,4-bis(4-methylstyryl) benzene, distyrylbenzene, 1,4-bis(2-ethylstyryl) benzene, 1,4-bis(3-ethylstyryl) benzene, 1,4-bis(2-methylstyryl) 2-methylbenzen; a distyrylpyrazine derivative such as 2,5-bis(4-methylstyryl) pyrazine, 2,5-bis(4-ethylstyryl) pyrazine, 2,5-bis[2-(1-naphthyl) vinyl] pyrazine, 2,5-bis(4-methoxystyryl) pyrazine, 2,5-bis[2-(4-biphenyl) vinyl] pyrazine, 2,5-bis[2-(1-pyrenyl) vinyl] pyrazine; a naphthalimide derivative; a perylene derivative; an oxadiazole derivative; an aldazine derivative; a cyclopentadiene derivative; a styrylamine derivative; a coumarin derivative; an aromatic dimethylidyne derivative; anthracene; salicylate; pyrene; and coronene. The material may also be phosphorescent material such as fac-tris(2-phenylpyridine) iridium.

Alternatively, the organic luminescent material may serve only the first function among the first to fourth functions, and materials in the light emitting layer other than the organic luminescent material may serve the second to fourth functions. In this case, the organic luminescent material that serves the first function is a dopant and the material that serves the second to fourth functions is a host.

Examples of the dopant include fluorescent material such as an europium complex, a benzopyran derivative, a rhodamine derivative, a benzothioxanthene derivative, a porphyrin derivative, a nile red, 2-(1,1-dimethylethyl)-6(2-(2,3,6,7-tetrahydro-1,1,7,7-tetramethyl-1H,5H-benzo(ij) quinolizin-9-yl) ethenyl)-4H-pyran-4-ylidene) propanedinitrile, which is abbreviated as DCJTB, DCM, a coumarin derivative, a quinacridone derivative, a distyrylamine derivative, a pyrene derivative, a perylene derivative, an anthracene derivative, a benzoxazole derivative, a benzothiazole derivative, benzoimidazole derivative, a chrysene derivative, a phenanthrene derivative, a distyrylbenzene derivative, a tetraphenylbutadiene, and a rubrene. The dopant may also be phosphorescent material that consists of a heavy metal complex. The phosphorescent material includes materials that emit green phosphorescence, such as tris(2-phenylpyridine)iridium, and materials that emit red phosphorescence, such as 2,3,7,8,12,13,17,18-octaethyl-21H23H-porphine platinum (II). The central metal of the heavy metal complex may be replaced with another metal or nonmetal.

Examples of the host material include a distyrylallylene derivative, a distyrylbenzene derivative, a distyrylamine derivative, a quinolinolato metal complex, a triarylamine derivative, an azomethine derivative, an oxadiazole derivative, a pyrazoloquinoline derivative, a silole derivative, a naphthalene derivative, an anthracene derivative, a dicarbazole derivative, a perylene derivative, an oligothiophene derivative, a coumarin derivative, a pyrene derivative, a tetraphenylbutadiene derivative, a benzopyran derivative, an europium complex, a rubrene derivative, a quinacridone derivative, a triazole derivative, a benzoxazole derivative, and a benzothiazole derivative.

The loading rate of the dopant (doping amount) to the host material is preferably between 0.01 wt% and 15 wt% inclusive.

The number of types of the organic luminescent material in the light emitting layer may be one or more. The light emitting layer may have a plurality of layers each consisting of organic luminescent material. The organic luminescent material included in each of the layers may be the same or different from each other.

When selecting the organic luminescent material, if each of the organic luminescent materials emit light the color of which is different from the color of light emitted from at least one of the other organic luminescent materials, or if each of the organic luminescent material emits light the peak wavelength of which is different from the peak wavelength of the light emitted from at least one of the other organic luminescent materials, the light emitted from the light emitting layer has a color that is a mixture of the light emitted from each of the organic luminescent materials. If, for example, selecting organic luminescent materials that emit red, blue, and green lights, respectively, for the organic luminescent materials to be included in the light emitting layer, the light emitted from the light emitting layer might be white.

When the single layer includes several types of dopants (organic luminescent materials), the light emitted from the layer has a mixed color of light emitted from each dopant. Furthermore, this might increase the efficiency of energy movement from the host to the dopant.

Examples of organic luminescent materials that emit red light include an europium complex, a benzopyran derivative, a rhodamine derivative, a benzothioxanthene derivative, a porphyrin derivative, a nile red, DCJTB, and DCM. Examples of organic luminescent materials that emit green light include a coumarin derivative and a quinacridone derivative. Examples of organic luminescent materials that emit blue light include a distyrylamine derivative, a pyrene derivative, a perylene derivative, an anthracene derivative, a benzoxazole derivative, a benzothiazole derivative, a benzimidazole derivative, a chrysene derivative, a phenanthrene derivative, a distyrylbenzene derivative, and a tetraphenylbutadiene. Examples of organic luminescent materials that emit yellow light include rubrene.

In a case where any the above mentioned organic luminescent materials are used as the dopant, the following materials are preferable for the host. Examples of a preferable host for a light emitting layer that emits red, green or yellow light, include a distyrylallylene derivative, a distyrylbenzene derivative, a distyrylamine derivative, a quinolinolato metal complex, a triarylamine derivative, an oxadiazole derivative, a silole derivative, a dicarbazole derivative, an oligothiophene derivative, a benzopyran derivative, a triazole derivative, a benzoxazole derivative, a benzothiazole derivative, Alq3, triphenylamine tetramer, and 4,4'-bis(2,2'-diphenylvinyl) biphenyl, which is abbreviated as DPVBi. Examples of a preferable host for a light emitting layer that emits blue light, include a distyrylallylene derivative, a stilbene derivative, a carbazole derivative, a triarylamine derivative, and bis(2-methyl-8-quinolinolato)(p-phenylphenolato)aluminum.

The light emitting layer may be formed by a vacuum vapor deposition method, a spin coat method, a cast method, or Langmuir-Blodgett (LB) method. The thickness of the light emitting layer may be from 1 nm to 100 nm inclusive, and preferably from 2 to 50 nm inclusive.

The chromaticity, saturation, brightness, and luminance of the light emitted from the light emitting layer is adjusted not only by selecting the types of materials that constitute the light emitting layer, but also by the loading rate of each material and the thickness of the light emitting layer.

The organic electroluminescent element 1 may include a layer that serves at least one of a hole injection function, an electron injection function, a hole transport function, and an electron transport function between the anode and the cathode, in addition to the light emitting layer. That is, the organic electroluminescent element 1 may include a group of elements shown in any one of (1) to (9). The order of elements in each group is the same as the order of the arrangement of the elements in the organic electroluminescent element 1.
(1) anode/hole injection layer/hole transport layer/light emitting layer/electron transport layer/electron injection layer/cathode;
(2) anode/hole injection layer/hole transport layer/light emitting layer/electron injection transport layer/cathode;
(3) anode/hole injection transport layer/light emitting layer/electron transport layer/electron injection layer/cathode;
(4) anode/hole injection transport layer/light emitting layer/electron injection transport layer/cathode;
(5) anode/light emitting layer/electron transport layer/electron injection layer/cathode;
(6) anode/light emitting layer/electron injection transport layer/cathode;
(7) anode/hole injection layer/hole transport layer/light emitting layer/cathode;
(8) anode/hole injection transport layer/light emitting layer/cathode; and
(9) anode/light emitting layer/cathode

Each layer arranged between the anode and the cathode except the light emitting layer may further have a function other than a hole injection function, an electron injection function, a hole transport function, and an electron transport function. The organic electroluminescent element 1 may further include a layer other than the above mentioned layers between the anode and the cathode.

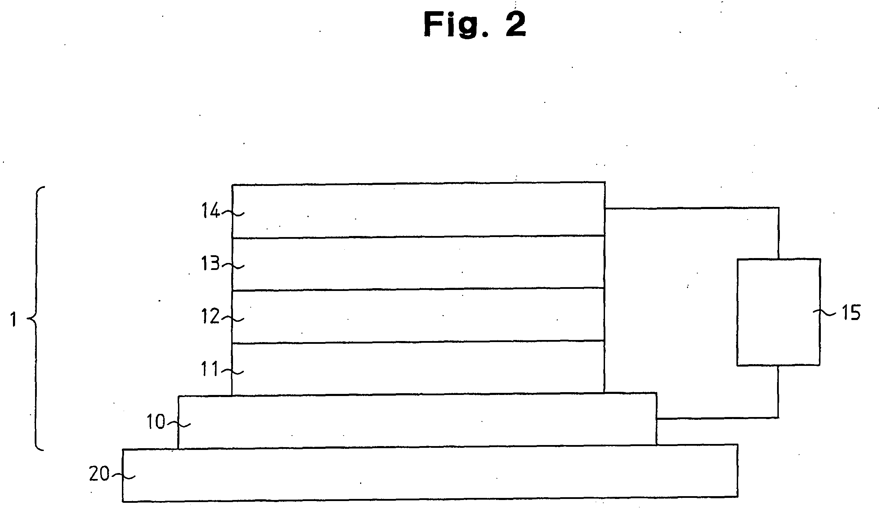

The organic electroluminescent element 1 shown in Fig. 2 is one example of an organic electroluminescent element 1 incorporated in the lighting system shown in Fig. 1. The organic electroluminescent element 1 includes an anode 10, a hole injection transport layer 11, a light emitting layer 12, an electron injection transport layer 13, a cathode 14, and a driving means (a driving circuit) 15. The elements other than the light emitting layer 12 in the organic electroluminescent element 1 shown in Fig. 2 and the elements other than the organic electroluminescent element 1 of the lighting system shown in Fig. 1 will now be described.

### <Anode 10>

The anode 10 functions to inject holes into the hole injection transport layer 11. The work function of the surface that contacts the hole injection transport layer 11 is preferably 4 eV. The materials for forming the anode 10 may be any kind of material such as a metal, an alloy, a conductive compound, or mixture of these. Examples of the materials include: metal oxide such as indium tin oxide (ITO), indium zinc oxide (IZO), tin oxide, zinc oxide, and zinc aluminum oxide; metal nitride such as titanium nitride; metal such as gold, platinum, silver, copper, aluminum, nickel, cobalt, lead, chromium, molybdenum, tungsten, tantalum, and niobium; an alloy containing these metals or copper iodide; and a conductive high polymer such as polyaniline, polythiophene, polypyrrole; polyphenylene vinylene, poly(3-methylthiophene), and polyphenylene sulfide.

In a case where the lighting system is a bottom emission type, that is, when the light emitted from the light emitting layer 12 is radiated through the surface of the organic electroluminescent element 1 that faces the substrate 20, or in a case where the lighting system is a top-and-bottom emission type, that is, when the light emitted from the light emitting layer 12 is radiated through the surface of the organic electroluminescent element 1 facing the substrate 20 and the surface of the organic electroluminescent element 1 facing away from the substrate 20, the anode 10 must permit light emitted from the light emitting layer 12 to pass through. In this case, the anode 10 preferably transmits 10% or more of the light emitted from the light emitting layer 12. To radiate light in the visible light range from the lighting system, the material for forming the anode 10 is preferably ITO, which reliably transmits light in the visible light range. On the other hand, in a case where the lighting system is a top emission type, that is, when the light emitted from the light emitting layer 12 is radiated through the surface of the organic electroluminescent element 1 facing away from the substrate 20, the anode 10 preferably has light reflectivity. In this case, the anode 10 is formed of a metal, an alloy, or a metallic compound.

The anode 10 may be made of a single material or of two or more materials. The anode 10 may also be formed by combining several of the same type of members or different types of members.

The anode 10 may be provided with an auxiliary electrode. The auxiliary electrode is formed of a metal such as copper, chromium, aluminum, titanium, and aluminum alloy, or by laminating these metals. Attaching the auxiliary electrode to part of the anode 10 reduces the electric resistance of the anode 10.

The anode 10 may be formed by a sputtering method, an ion plating method, a vacuum vapor deposition method, a spin coat method, or an electronic beam vapor deposition method. The surface of the anode 10 is preferably subjected to ozone cleaning or oxygen plasma cleaning. This is because, after being subjected to ozone cleaning or oxygen plasma cleaning, the surface of the anode 10 has a high work function. The mean square value of the surface roughness of the anode 10 is preferably equal to or less than 20 nm so that defects such as short circuits on organic electroluminescent elements are reduced. The surface roughness of the anode 10 can be decreased by forming the anode 10 with material of a minute particle diameter, or by grinding the surface of the formed anode 10.

The thickness of the anode 10 may be between 5 nm and 1 µm inclusive, preferably between 10 nm and 1 µm inclusive, more preferably between 10 nm and 500 nm inclusive, further preferably between 10 nm and 300 nm inclusive, and most preferably between 10 nm and 200 nm inclusive. The electric resistance of the anode 10 is preferably equal to or less than several hundreds of ohms/sheet, and more preferably between 5 ohms/sheet and 50 ohms/sheet inclusive.

### <Hole Injection Transport Layer 11>

The hole injection transport layer 11 is provided between the anode 10 and the light emitting layer 12. The hole injection transport layer 11 receives holes injected from the anode 10 and transports the injected holes to the light emitting layer 12. The ionization energy of the hole injection transport layer 11 may be between the work function of the anode 10 and the ionization energy of the light emitting layer 12, and more specifically, between 5.0eV to 5.5eV inclusive.

The hole injection transport layer 11 provides the following four advantages to the organic electroluminescent element 1 shown in Fig 2. The first advantage is that the drive voltage of the organic electroluminescent element 1 is reduced. The second advantage is that, since the injection of holes from the anode 10 to the light emitting layer 12 is stabilized, the lifetime of the organic electroluminescent element 1 is extended. The third advantage is that, since the anode 10 intimately contacts the light emitting layer 12, the homogeneity of the light emitting surface of the organic electroluminescent element 1 is improved. The fourth advantage is that, since projections on the surface of the anode 10 are covered, the failure rate is reduced.

The hole injection transport layer 11 is formed, for example, one or more of a phthalocyanine derivative, a triazole derivative, a triarylmethane derivative, a triarylamine derivative, a oxazole derivative, an oxadiazole derivative, a hydrazone derivative, a stilbene derivative, a pyrazoline derivative, a pyrazolone derivative, a polysilane derivative, an imidazole derivative, a phenylenediamine derivative, an amino group replaced chalcone derivative, a styryl anthracene derivative, a fluorenone derivative, a hydrazone derivative, a silazane derivative, an aniline copolymer, a porphyrin compound, a polyarylalkane derivative, polyphenylenevinylene or its derivative, polythiophene or its derivative, a poly-N-vinylcarbazole derivative, a conductive high polymer oligomer such as thiophene oligomer, metal phthalocyanine such as copper phthalocyanine and tetra (t-butyl) copper phthalocyanine, metal-free phthalocyanine, a quinacridone compound, an aromatic tertiary amine compound, a styrylamine compound, and an aromatic dimethylidyne compound.

Examples of the triarylamine derivative include 4,4'-bis[N-phenyl-N-(4"-methylphenyl) amino] biphenyl, 4,4'-bis [N-phenyl-N-(3"-methylphenyl) amino] biphenyl, 4,4'-bis [N-phenyl-N-(3''-methoxyphenyl) amino] biphenyl, 4,4'-bis [N-phenyl-N-(1''-naphthyl) amino] biphenyl, 3,3'-dimethyl-4,4'-bis [N-phenyl-N-(3''-methylphenyl) amino] biphenyl, 1,1-bis [4'-[N,N-di(4''-methylphenyl) amino] phenyl] cyclohexane, 9,10-bis[N-(4'-methylphenyl)-N-(4''-n-butylphenyl) amino] phenanthrene, 3,8-bis[N,N-diphenylamino)-6-phenylphenanthridine, 4-methyl-N,N-bis[4'',4'''-bis[N',N''-di(4-methylphenyl)amino]biphenyl-4-yl]aniline, N,N''-bis[4-(diphenylamino)phenyl]-N,N'-diphenyl-1,3-diaminobenzene, N,N'-bis[4-(diphenylamino)phenyl]-N,N'-diphenyl-1,4-diaminobenzene, 5,5" -bis[4-(bis[4-methylphenyl]amino)phenyl]-2,2':5',2"-terthiophene, 1,3,5-tris(diphenylamino)benzene, 4,4',4''-tris(N-carbazolyl)triphenylamine, 4,4',4''-tris(N-3'''-methylphenyl)-N-phenylamino]triphenylamine, 4,4',4''-tris(N,N-bis(4'''-tert-butylbiphenyl-4''''-yl)amino]triphenylamine, and 1,3,5-tris[N-(4'-diphenylaminophenyl)-N-phenylamino]benzene.

Examples of the porphyrin compound include porphin, 1,10,15,20-tetraphenyl-21H,23H-porphin copper(II), 1,10,15,20-tetraphenyl-21H,23H-porphin zinc(II), 5,10,15,20-tetrakis(pentafluorophenyl)-21H,23H-porphin, silicon phthalocyanine oxide, aluminum phthalocyanine chloride, metal-free phthalocyanine, dilithium phthalocyanine, copper tetramethyl phthalocyanine, copper phthalocyanine, chromium phthalocyanine, zinc phthalocyanine, lead phthalocyanine, titanium phthalocyanine oxide, magnesium phthalocyanine, and copper octamethyl phthalocyanine.

Examples of the aromatic tertiary amine compound and the styrylamine compound include N,N,N',N'-tetraphenyl-4,4'-diaminophenyl, N,N'-diphenyl-N,N'-bis-(3-methylphenyl)-[1,1'-biphenyl]-4,4'-diamine, 2,2-bis(4-di-p-tolylaminophenyl) propane, 1,1-bis(4-di-p-tolylaminophenyl)cyclohexane, N,N,N',N'-tetra-p-tolyl-4,4'-diaminophenyl, 1,1-bis(4-di-p-tolylaminophenyl)-4-phenylcyclohexane, bis(4-dimethylamino-2-methylphenyl)phenylmethane, bis(4-di-p-tolylaminophenyl) phenylmethane, N,N'-diphenyl-N,N'-di(4-methoxyphenyl)-4,4'-diaminobiphenyl, N,N,N',N'-tetraphenyl-4,4'-diaminophenyl ether, 4,4'-bis(diphenylamino)quadriphenyl, N,N,N-tri(p-tolyl)amine, 4-(di-p-tolylamino)-4'-[4(di-p-tolylamino)styryl)stilbene, 4-N,N-diphenylamino-(2-diphenylvinyl) benzene, 3-methoxy-4'-N,N-diphenylaminostilbenzene, and N-phenylcarbazole.

If the lighting system is a bottom emission type or a top-and-bottom emission type, the hole injection transport layer 11 must permit light emitted by the light emitting layer 12 to pass through. In this case, the hole injection transport layer 11 preferably transmits 10% or more of the light emitted from the light emitting layer 12.

The hole injection transport layer 11 may be made of a single material or of a two or more materials. The hole injection transport layer 11 may also be formed by combining several of the same type of members or different types of members.

The hole injection transport layer 11 may be formed by a vacuum vapor deposition method, a spin coat method, a cast method, or an LB method. The thickness of the hole injection transport layer 11 may be between 5 nm and 5 µm inclusive.

### <Electron Injection Transport Layer 13>

The electron injection transport layer 13 is provided between the light emitting layer 12 and the cathode 14. The electron injection transport layer 13 receives electrons injected by the cathode 14 and transports the electrons to the light emitting layer 12. The electron injection transport layer 13 provides the following four advantages to the organic electroluminescent element 1 shown in Fig 2. The first advantage is that the drive voltage of the organic electroluminescent element 1 is reduced. The second advantage is that, since the injection of electrons from the cathode 14 to the light emitting layer 12 is stabilized, the lifetime of the organic electroluminescent element 1 is extended. The third advantage is that, since the cathode 14 intimately contacts the light emitting layer 12, the homogeneity of the light emitting surface of the organic electroluminescent element 1 is improved. The fourth advantage is that, since projections on the surface of the cathode 14 are covered, the failure rate is reduced.

The electron injection transport layer 13 is formed of an arbitrary material the electron affinity of which is between the work function of the cathode 14 and the electron affinity of the light emitting layer 12. Examples of materials for forming the electron injection transport layer 13 include: an oxadiazole derivative such as 1,3-bis[5'-(p-tert-butylphenyl)-1,3,4-oxadiazole-2'-yl]benzene, 2-(4-biphenylyl)-5-(4-t-butylphenyl)-1,3,4-oxadiazole; a triazole derivative such as 3-(4'-tert-butylphenyl)-4-phenyl-5-(4''-biphenyl)-1,2,4-triazole; a triazine derivative; a perylene derivative; a quinoline derivative; a quinoxaline derivative; diphenylquinone derivative; a nitro group replaced fluorenone derivative; a thiopyran dioxide derivative; an anthraquino-dimethane derivative; a heterocyclic tetracarboxylic acid anhydride such as naphthalene perylene; carbodiimide; a fluorenylidene methane derivative; an anthraquino dimethane derivative; an anthrone derivative; a distyrylpyrazine derivative; an organometallic complex such as bis(10-benz[h]quinolinolato)beryllium, a beryllium salt of 5-hydroxyflavone, and an aluminum salt of 5-hydroxyflavone; a metal complex of 8-hydroxyquinoline or a metal complex of an 8-hydroxyquinoline derivative; and metal-free or metal phthalocyanine, or metal-free or metal phthalocyanine the end group of which is replaced by a alkyl group or a sulfone group. Examples of 8-hydroxyquinoline or a metal complex of an 8-hydroxyquinoline derivative include oxinoid chelated metal compound such as tris(8-quinolinol)aluminum, tris(5,7-dichloro-8-quinolinol) aluminum, tris(5,7-dibromo-8-quinolinol)aluminum, tris(2-methyl-8-quinolinol)aluminum. The central metal of these metal complexes may be replaced by indium, magnesium, copper, calcium, tin, or lead.

In a case where the lighting system is a top emission type or a top-and-bottom emission type, the electron injection transport layer 13 must permit the light emitted by the light emitting layer 12 to pass through. In this case, the electron injection transport layer 13 preferably transmits 10% or more of the light emitted from the light emitting layer 12.

The electron injection transport layer 13 may be made of a single material or of two or more materials. The electron injection transport layer 13 may also be formed by combining several of the same type of members or different types of members.

The electron injection transport layer 13 may be formed by a sputtering method, an ion plating method, a vacuum vapor deposition method, a spin coat method, or an electronic beam vapor deposition method. The thickness of the electron injection transport layer 13 may be between 5 nm and 5 µm inclusive.

### <Cathode 14>

The cathode 14 functions to inject electrons into the electron injection transport layer 13. The work function of the cathode 14 may be less than 4.5 eV. To increase the electron injection efficiency, the work function of the cathode 14 is preferably less than or equal to 4.0 eV, and more preferably less than or equal to 3.7 eV. The material for forming the cathode 14 may be any type such as a metal, an alloy, a conductive compound, and a mixture of these materials. Examples of materials include lithium, sodium, magnesium, gold, silver, copper, aluminum, indium, calcium, tin, ruthenium, titanium, manganese, chromium, yttrium, an aluminum-calcium alloy, an aluminum-lithium alloy, an aluminum-magnesium alloy, a magnesium-silver alloy, a magnesium-indium alloy, a lithium-indium alloy, a sodium-potassium alloy, a mixture of magnesium and copper, and a mixture of aluminum and aluminum oxide. The above mentioned materials for forming the anode 10 may be used as the material for forming the cathode 14.

If the lighting system is a top emission type or a top-and-bottom emission type, the cathode 14 must permit light emitted by the light emitting layer 12 to pass through. In this case, the cathode 14 preferably transmits 10% or more of the light emitted from the light emitting layer 12. On the other hand, if the lighting system is a bottom emission type, the cathode 14 preferably has light reflectivity. In this case, the cathode 14 is formed of a metal, alloy, or metallic compound.

The cathode 14 may be formed by laminating a thin film formed of a magnesium-silver alloy and a transparent conductive oxide. In this case, a buffer layer to which copper phthalocyanine is added is preferably located between the cathode 14 and the electron injection transport layer 13 to prevent the light emitting layer 12 from being damaged by plasma during sputtering of the conductive oxide.

The cathode 14 may be made of a single material or of two or more materials. For example, if made of magnesium with 5 to 10% inclusive of silver or copper added thereto, the cathode 14 is less likely to be oxidized and can be brought into closer contact with the electron injection transport layer 13.

The cathode 14 may also be formed by combining several of the same type of members or different types of members. For example, to prevent oxidation, a protective layer of metal having corrosion resistance such as silver and aluminum may be formed on a surface of the cathode 14 that does not contact the electron injection transport layer 13. Alternatively, to decrease the work function of the cathode 14, a layer made of any of an oxide, a fluoride, a metal, and a compound that have small work functions may be formed on a surface of the cathode 14 that contacts the electron injection transport layer 13. For example, if the cathode 14 is made of aluminum, a layer made of lithium fluoride or lithium oxide may be formed on a surface of the cathode 14 that contacts the electron injection transport layer 13.

The cathode 14 may be formed by a vacuum vapor deposition method, a sputtering method, an ionization deposition method, an ion plating method, or an electronic beam vapor deposition method. The thickness of the cathode 14 may be between 5 nm and 1 µm inclusive, preferably between 10 nm and 500 nm inclusive, and more preferably between 50 nm and 200 nm inclusive. The electric resistance of the cathode 14 is preferably equal to or less than several hundreds of ohms/sheet.

### <Driving Means (Driving Circuit) 15>

The driving means (driving circuit) 15 supplies current from the anode 10 to the cathode 14, and has a known structure.

### <Substrate 20>

The substrate 20 is a plate-like member, which supports the organic electroluminescent element 1. The surface of the substrate 20 is preferably smooth. If the lighting system is a bottom emission type or a top-and-bottom emission type, the substrate 20 must permit light emitted by the light emitting layer 12 to pass through. The substrate 20 may be formed of, for example, plastic, metal, or ceramics such as glass, silicon, and quartz. The substrate 20 may be formed by combining several same of the type of members or different types of members. For example, the substrate 20 may be formed by overlaying a metal foil on a plastic base.

### <Columnar Support 21 and Seat 22>

A columnar support 21 and a seat 22 form a stand for maintaining the organic electroluminescent element 1, which is attached to the substrate 20, at a predetermined position. The columnar support 21 has a proximal end connected to the seat 22 and a distal end connected to the substrate 20. The ground contact area of the seat 22 is sufficient for supporting the organic electroluminescent element 1.

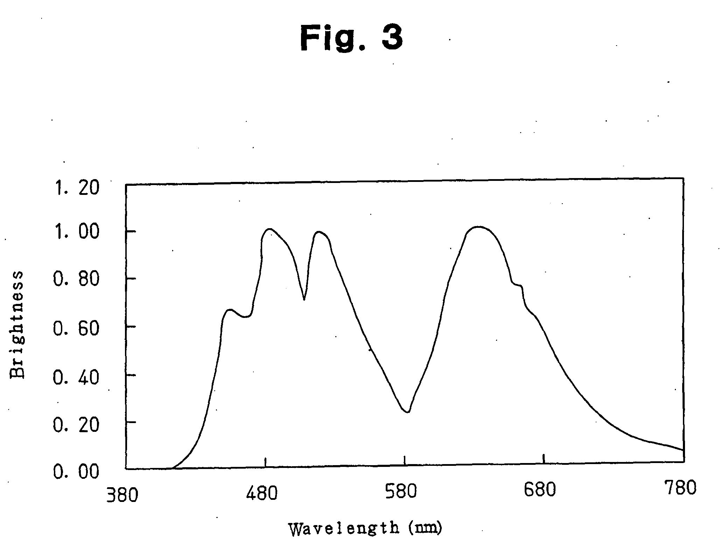

The preferred embodiment provides the following advantages.
(1) The organic electroluminescent element 1 of the preferred embodiment emits light having a wavelength of no less than 380 nm and no more than 800 nm and does not emit light having a wavelength of less than 380 nm. Therefore, the lighting system of the preferred embodiment having the organic electroluminescent element 1 does not emit light having a wavelength of less than 380 nm. In general, insects are attracted to light having a wavelength of approximately 360 nm (ultraviolet light). Therefore, the lighting system of the preferred embodiment, which does not emit light having a wavelength of less than 380 nm, is suitable for lighting places where attraction of insects is undesirable, such as places where food is handled or where medical practice takes place. The lighting system of the preferred embodiment is also suitable for lighting exhibits such as art objects and clothing that are likely to deteriorate by, for example, color fading, due to exposure to ultraviolet light. Furthermore, the lighting system of the preferred embodiment is suitable for lighting places where people who should not be exposed to ultraviolet light, such as patients having a light-sensitive disorder or patients having xeroderma pigmentosum syndrome, are likely to be exposed to the light.
(2) The organic electroluminescent element 1 of the preferred embodiment emits light having a wavelength of no less than 380 nm and no more than 800 nm, and does not emit light having a wavelength of greater than 800 nm. Therefore, the lighting system of the preferred embodiment having the organic electroluminescent element 1 does not emit light having a wavelength of greater than 800 nm. Thus, the lighting system of the preferred embodiment is suitable for lighting places where exposure to infrared light is undesirable, such as for lighting objects that are likely to deteriorate by exposure to light having a wavelength of greater than 800 nm, or infrared light.
(3) The organic electroluminescent element 1 of the preferred embodiment emits not only light having a peak wavelength, but also light having a wavelength other than the peak wavelength (see Fig. 3). Therefore, the lighting system of the preferred embodiment emits light having a broad spectrum of wavelengths as compared to a conventional lighting system such as a fluorescent light. Thus, if objects having a neutral color portion, particularly, art objects or clothing that heavily use a neutral color are illuminated with the lighting system of the preferred embodiment, the illuminated objects take on vivid colors.
   The organic electroluminescent element 1 that emits light having the spectrum shown in Fig. 3 is manufactured by the following preferred procedure.
   First, a transparent glass substrate 20 is prepared. The anode 10, which is made of ITO, is formed on the substrate 20. The thickness of the anode 10 is 220nm. The substrate 20 is then subjected to alkali cleaning and deionized water cleaning. After being dried, the substrate 20 is further subjected to ultraviolet ozone cleaning. The substrate 20, which has been through the cleaning process, is moved to a vacuum deposition device. Triphenylamine tetramer (chemical formula 1) is deposited on the surface of the anode 10 using a carbon crucible at a deposition speed of 0.1 nm/s and a vacuum of approximately 5.0 × 10⁻⁵Pa. Accordingly, a hole injection transport layer 11, the thickness of which is 80 nm, is formed on the surface of the anode 10. 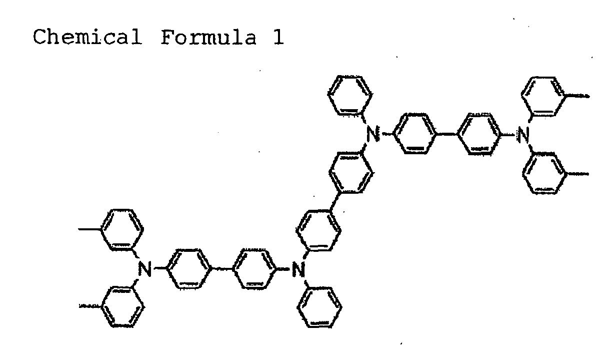
   Subsequently, part of the hole injection transport layer 11 is covered with a first mask except some portions, each having a width of 50 nm and a length of 1 mm. A mixture of 99 wt% Alq3 (chemical formula 2) and 1 wt% DCJTB (chemical formula 3) is deposited on the portions that are not covered by the first mask. The deposition is performed using a carbon crucible at a deposition speed of 0.1 nm/s and a vacuum of approximately 5.0 × 10⁻⁵Pa. This forms red light emitting portions each having a thickness of 30 nm. After removing the first mask, part of the surface of the hole injection transport layer 11 is covered with a second mask, except some portions, each located 5 nm apart from the corresponding red light emitting portion and having a width of 50 nm and a length of 1 mm. A mixture of 99 wt% Alq3 and 1 wt% 2,3,5,6-1H,4H-tetrahydro-9-(2'benzothiazolyl) quinolizino[9,9a,1-gh] coumarin is deposited on the portions of the surface of the hole injection transport layer 11 that are not covered with the second mask. The deposition is performed using a carbon crucible at a deposition speed of 0.1 nm/s and a vacuum of approximately 5.0 × 10⁻⁵Pa. This forms green light emitting portions each having a thickness of 30 nm. After removing the second mask, part of the surface of the hole injection transport layer 11 is covered with a third mask, except some portions, each located 5 nm apart from the corresponding green light emitting portion and having a width of 50 nm and a length of 1 mm. A mixture of 97 wt% DPVBi (chemical formula 4) and 3 wt% BCzVBi (chemical formula 5) is deposited on the portions of the surface of the hole injection transport layer 11 that are not covered with the third mask. The deposition is performed using a carbon crucible at a deposition speed of 0.1 nm/s and a vacuum of approximately 5.0 × 10⁻⁵Pa. This forms blue light emitting portions each having a thickness of 30 nm. The red light emitting portions, the green light emitting portions, and the blue light emitting portions constitute the light emitting layer 12. 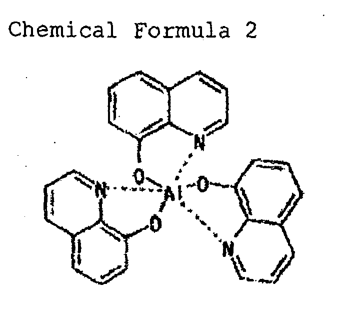 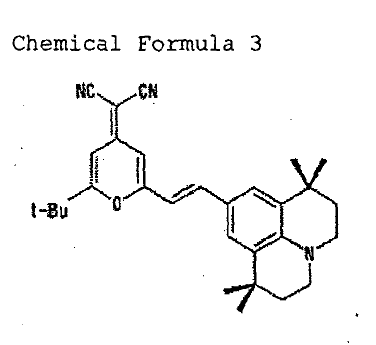 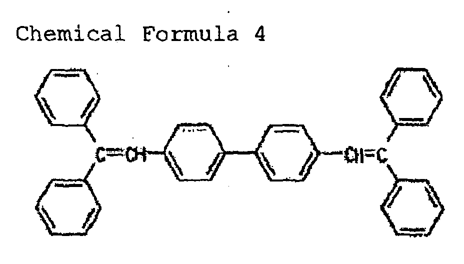 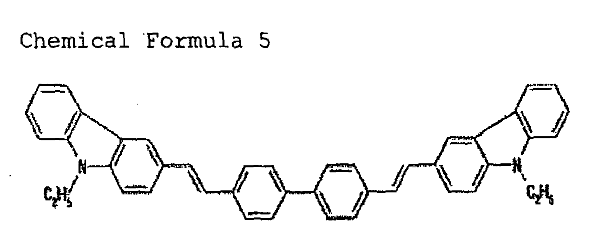
   Furthermore, 2,5-bis(6'-(2',2" -bipyridyl))-1,1-dimethyl-3,4-diphenylsilole (chemical formula 6) is deposited on the surface of the light emitting layer 12 using a carbon crucible at a deposition speed of 0.1 nm/s and a vacuum of approximately 5.0 × 10⁻⁵Pa. This forms an electron injection transport layer 13 having a thickness of 15 nm. After forming the electron injection transport layer 13, aluminum is deposited on the surface of the electron injection transport layer 13 on a tungsten boat at a deposition speed of 1 nm/s and a vacuum of approximately 5.0 × 10⁻⁵Pa. This forms a cathode 14 having a thickness of 150 nm. An organic electroluminescent element 1 manufactured through the above-described procedure is subsequently sealed with a passivation film. Furthermore, the driving means (driving circuit) 15 is connected to the anode 10 and the cathode 14. 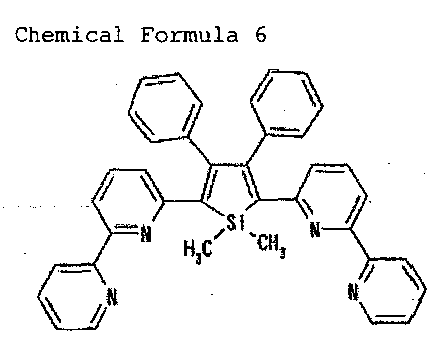
   The numeric values of the vertical axis of the graph shown in Fig. 3 represent relative brightness under the condition that the brightness of light having a wavelength of 500 nm emitted from the organic electroluminescent element 1 is defined as one. The brightness is measured using a luminance meter manufactured by TOPCON CORPORATION. The brand name of the luminance meter is "BM7".
(4) The spectrum of light emitted from the organic electroluminescent element 1 is variable according to the type and amount of organic luminescent material contained in the light emitting layer 12, addition of additives to the light emitting layer 12, and the thickness of the light emitting layer 12. Therefore, according to the preferred embodiment, a lighting system that is suitable for the purpose is provided.
(5) The lighting system according to the preferred embodiment provides flexibility of in design as compared to a conventional lighting system, such as a fluorescent light and an incandescent light. This is because the design of the lighting system of the preferred embodiment is determined by the design of the substrate 20, which provides great flexibility in design.
(6) The thickness of the organic electroluminescent element 1 is very thin. The thickness of the lighting system is thus substantially the same as the thickness of the substrate 20. Therefore, the lighting system of the preferred embodiment has reduced thickness as compared to a conventional lighting system. Furthermore, the thickness of the lighting system can be further reduced by sandblasting the surface of the substrate 20 that is opposite to the surface on which the organic electroluminescent element 1 is formed. The thin lighting system provides for a wide variety of applications that are suitable, as compared to a conventional thick lighting system. For example, the thin lighting system can be used in narrow places.
(7) The physical strength of the lighting system is increased as compared to a lighting system that uses a fluorescent light or an incandescent light. In a case where the substrate 20 is flexible since the substrate 20 is made of, for example, acrylic resin, the lighting system of the preferred embodiment has greater physical strength as compared to a conventional lighting system that is formed by glass, such as a fluorescent light or an incandescent light.

It should be apparent to those skilled in the art that the present invention may be embodied in many other specific forms without departing from the spirit of scope of the invention. Particularly, it should be understood that the invention may be embodied in the following forms.

In the preferred embodiment, the organic luminescent material in the light emitting layer 12 is made only of a material that emits light having a wavelength of no less than 380 nm and no more than 800 nm. However, the organic luminescent material may be made only of a material that emits light the peak wavelength of which is within the visible light range. This modified example provides substantially the same advantages as the preferred embodiment. A material that only emits light the peak wavelength of which is within the visible light range includes an organic luminescent material described in the preferred embodiment.

The organic luminescent material in the light emitting layer 12 may be made of only materials that emit light having a wavelength no less than 380 nm on condition that at least one of the materials emits light having a wavelength of which is no more than 800 nm. This modified example also provides substantially the same advantages as the preferred embodiment. The material that emits light the wavelength of which is no less than 380 nm and the material that emits light the wavelength of which is no less than 380nm and no more than 800 nm include the organic luminescent material described in the preferred embodiment.

The lighting system according to the preferred embodiment may be used as a backlight for a display.

The columnar support 21 and the seat 22 may be omitted.

The organic electroluminescent element 1 of the preferred embodiment may include other elements in addition to the anode 10, the hole injection transport layer 11, the light emitting layer 12, the electron injection transport layer 13, the cathode 14, and the driving means (driving circuit) 15. An element may be provided for improving intimate contact between the adjacent elements or for more smoothly injecting the electrons or the holes.

For example, a cathode interface layer may be provided between the electron injection transport layer 13 and the cathode 14. The cathode interface layer lowers the energy barrier against the injection of electrons from the cathode 14 to the light emitting layer 12, and improves intimate contact between the electron injection transport layer 13 and the cathode 14. The cathode interface layer may be made of alkali metal fluoride, alkali metal oxide, alkali metal chloride, alkali metal sulfide, alkaline-earth metal fluoride, alkaline-earth metal oxide, alkaline-earth metal chloride, or alkaline-earth metal sulfide. More specifically, the cathode interface layer may be made of lithium fluoride, lithium oxide, magnesium fluoride, calcium fluoride, strontium fluoride, or barium fluoride. The cathode interface layer may be made of a single material or of two or more materials. The thickness of the cathode interface layer may be between 0.1 nm and 10 nm inclusive, and preferably between 0.3 nm and 3 nm inclusive. The cathode interface layer may have either an even thickness or an uneven thickness. The cathode interface layer may be shaped like islands. The cathode interface layer may be formed by a vacuum vapor deposition method.

Alternatively, the organic electroluminescent element 1 may be covered by a protective layer (passivation film) that seals the element 1 against oxygen or water. The protective layer may be made of an organic polymer material, inorganic material, or photo-curing resin. The protective layer may be made of a single material or of two or more materials. The protective layer may also have multilayered structure. Examples of the organic polymer material include: fluorocarbon resin, such as a chlorotrifluoroethylene polymer, a dichlorodifluoroethylene polymer, or a copolymer of a chlorotrifluoroethylene polymer and a dichlorodifluoroethylene polymer; an acrylic resin such as polymethyl methacrylate and polyacrylate; an epoxy resin; a silicone resin; an epoxy silicone resin; a polystyrene resin; a polyester resin; a polycarbonate resin; a polyamide resin; a polyimide resin, a polyamideimide resin; a polyparaxylene resin; a polyethylene resin; and a polyphenylene oxide resin. Examples of the inorganic material include a diamond film, amorphous silica, electrical insulation glass, metal oxide, metal nitride, metal carbide, and metal sulfide. A fluorescence conversion substance may be added to the protective layer.

To prevent contact with oxygen or water, the organic electroluminescent element 1 may be sealed in an inert substance such as paraffin, liquid paraffin, silicone oil, fluorocarbon oil, and fluorocarbon oil with added zeolite.

In the preferred embodiment, the anode 10, the hole injection transport layer 11, the light emitting layer 12, the electron injection transport layer 13, and the cathode 14 may be doped with additives (dopant).

For example, the hole injection transport layer 11 or the electron injection transport layer 13 may be doped with an organic luminescent material (dopant), such as a fluorescent material or a phosphorescent material. In this case, the hole injection transport layer 11 and the electron injection transport layer 13 can emit electroluminescence.

Alternatively, when the cathode 14 is made of a metal such as aluminum, the electron injection transport layer 13 may be doped with an alkali metal or an alkali metal compound to lower the energy barrier between the cathode 14 and the light emitting layer 12. The doped alkali metal or alkali metal compound reduces the light emitting layer 12. As a result, anions are generated in the light emitting layer 12. This promotes injection of electrons from the cathode 14 to the light emitting layer 12. The voltage required for electroluminescence is thus lowered. Examples of the alkali metal compound include oxide, fluoride, and lithium chelate.

The present examples and embodiments are to be considered as illustrative and not restrictive and the invention is not to be limited to the details given herein, but may be modified within the scope and equivalence of the appended claims.

An organic electroluminescent element including an organic luminescent material having electroluminescent characteristics and which suppresses generation of ultraviolet light. The organic luminescent material is made only of a material that emits light having a wavelength of no less than 380 nm and no more than 800 nm.

## Claims

1. An organic electroluminescent element comprising an organic luminescent material having electroluminescent characteristics and which suppresses generation of ultraviolet light, **characterized in that** the organic luminescent material is made only of a material that emits light having a wavelength of no less than 380 nm and no more than 800 nm.

2. An organic electroluminescent element comprising an organic luminescent material having electroluminescent characteristics and which suppresses generation of ultraviolet light, **characterized in that** the organic luminescent material is made only of a material that emits light having a peak wavelength of which that is within a visible light range.

3. The organic electroluminescent element according to claim 1 or 2, **characterized in that** the organic luminescent material is one of a plurality of organic luminescent materials which are contained in the organic electroluminescent element, and wherein each organic luminescent material emits light the color of which is different from the color of light emitted from at least one of the other organic luminescent materials.

4. The organic electroluminescent element according to claim 1 or 2, **characterized in that** the organic luminescent material is one of a plurality of organic luminescent materials which are contained in the organic electroluminescent element, and wherein each organic luminescent material emits light having a peak wavelength that is different from the peak wavelength of light emitted from at least one of the other organic luminescent materials.

5. The organic electroluminescent element according to claim 1 or 2, **characterized in that** the organic luminescent material is one of a plurality of organic luminescent materials which are contained in the organic electroluminescent element, and wherein the organic luminescent materials include an organic luminescent material that emits red light, an organic luminescent material that emits blue light, and an organic luminescent material that emits green light.

6. An organic electroluminescent element comprising a plurality of organic luminescent materials having electroluminescent characteristics and which suppresses generation of ultraviolet light, **characterized in that** the organic luminescent materials are made only of materials that emit light having a wavelength of no less than 380 nm, and wherein light emitted from at least one of the organic luminescent materials has a wavelength of no more than 800 nm.

7. The organic electroluminescent element according to claim 6, **characterized in that** each organic luminescent material emits light the color of which is different from the color of light emitted from at least one of the other organic luminescent materials.

8. The organic electroluminescent element according to claim 6, **characterized in that** each organic luminescent material emits light having a peak wavelength that is different from the peak wavelength of light emitted from at least one of the other organic luminescent materials.

9. The organic electroluminescent element according to claim 6, **characterized in that** the organic luminescent materials include an organic luminescent material that emits red light, an organic luminescent material that emits blue light, and an organic luminescent material that emits green light.

10. A lighting system for suppressing generation of ultraviolet light, the lighting system **characterized by**:
a substrate; and
the organic electroluminescent element according to any one of claims 1 to 9, wherein the organic electroluminescent element is located on the substrate.

11. The lighting system according to claim 10, **characterized in that** the lighting system is used for lighting a place where attraction of insects is not desired.

12. The lighting system according to claim 10, **characterized in that** the lighting system is used for lighting a place where a patient having a light-sensitive disorder is likely to be exposed to light.

13. The lighting system according to claim 10, **characterized in that** the lighting system is used for lighting a place where a patient having xeroderma pigmentosum syndrome is likely to be exposed to light.

14. The lighting system according to claim 10, **characterized in that** the lighting system is used for lighting an exhibit.
